# EUROPEAN PATENT APPLICATION

(11) **EP 2 755 457 A1**
(43) Date of publication of application: **16.07.2014**
(21) Application number: 13193842.5
(22) Date of filing: 21.11.2013
(51) Int. Cl.: H05K 1/02

(54) **Printed circuit board and manufacturing method of printed circuit board**

(30) Priority: 15.01.2013 JP 2013004440
(71) Applicant: FUJITSU LIMITED, Kawasaki-shi, Kanagawa 211-8588 (JP)
(72) Inventor: Kawai, Kenichi, Kanagawa, 211-8588 (JP)
(74) Representative: HOFFMANN EITLE

(57) **Abstract**

A printed circuit board includes a plurality of wiring layers and a plurality of differential signal vias to establish connections between the plurality of wiring layers through via pairs and to be disposed so that paired-vias possessed by a specified differential signal via for transmitting a differential signal different from a signal of another differential signal via adjacent thereto are arranged on a locus of a point distanced equally from each of the paired-vias possessed by another differential signal via.

## Description

### FIELD

The embodiments discussed herein are related to a printed circuit board and a manufacturing method of a printed circuit board.

### BACKGROUND

Over the recent years, a processing speed of electronic equipment such as a computer has got faster and faster. For example, computerbusarchitecture, inwhichatransmissionspeed is set to 8 Gbps according to "PCI Express (Registered Trademark) Gen 3", is requested to perform transmission much faster from now into the future. Supportability for a speeding-up scheme entails further improving a transmitting characteristic, a reflecting characteristic and a crosstalk in a transmission path. Such being the case, pieces of electronic equipment in recent years, which use differential signals exhibiting superiority in terms of a noise margin rather than single-ended signals, are on the verge of spreading (refer to, e.g., Patent document 1).

### [Documents of Prior Arts]

### [Patent document]

[Patent document 1] Japanese Laid-Open Publication No.2007-287750
[Patent document 2] Japanese National Publication of International Patent Application No.2008-521180
[Patent document 3] Japanese National Publication of International Patent Application No.2008-526034

### SUMMARY

The differential signal is superior in terms of the noise margin to the single-ended signal but is requested to be further improved for the supportability for the speeding-up scheme of the electronic equipment from now into the future. For example, on a printed circuit board including a plurality of wiring layers, in the case of transmitting the differential signals, it follows that vias establishing connections between the wiring layers are paired and thus used for transmitting the signals. The vias used for transmitting the signals are paired, the number of the vias used for transmitting the signals increases, while a space for installing GND vias for preventing crosstalks decreases.

Undersuchcircumstances, thepresentapplicationaims at providing a printed circuit board and a manufacturing method of a printed circuit board that restrain crosstalks of paired-vias taking charge of transmitting differential signals.

The present application discloses a printed circuit board that follows.
A printed circuit board including:
a plurality of wiring layers; and
a plurality of differential signal vias to establish connections between the plurality of wiring layers through via pairs and to be disposed so that paired-vias possessed by a specified differential signal via for transmitting a differential signal different from a signal of another differential signal via adjacent thereto are arranged on a locus of a point distanced equally from each of the paired-vias possessed by another differential signal via.

Further, the present application discloses a manufacturing method of a printed circuit board, which follows.
A manufacturing method of a printed circuit board, including:
forming, on a plurality of wiring layers, a plurality of differential signal vias to establish connections between the plurality of wiring layers through via pairs and to be disposed so that paired-vias possessed by a specified differential signal via for transmitting a differential signal different from a signal of another differential signal via adjacent thereto are arranged on a locus of a point distanced equally from each of the paired-vias possessed by another differential signal via.

The printed circuit board and the manufacturing method of the printed circuit board restrain crosstalks of the paired-vias taking charge of transmitting differential signals.

### BRIEF DESCRIPTION OF THE DRAWINGS

FIG. 1 is one example of a diagram illustrating aprinted circuit board according to an embodiment;
FIG. 2 is one example of a diagram simulating a positional relation between an electric field generated between vias when differential signals flow to differential signal vias and adjacent differential signal vias;
FIG. 3 is one example of a diagram simulating a magnetic field profile of a magnetic field generated when the differential signals flow to the differential signal vias;
FIG. 4 is one example of a diagram illustrating a printed circuit board according to a first comparative example;
FIG. 5 is one example of a diagram illustrating a printed circuit board according to a second comparative example;
FIG. 6 is one example of a diagram illustrating a crosstalk set as a calculation target with respect to the printed circuit board according to the embodiment;
FIG. 7 is one example of a diagram illustrating the crosstalk set as the calculation target with respect to a printed circuit board according to a first comparative example;
FIG. 8 is one example of a diagram depicting the crosstalk set as the calculation target with respect to a printed circuit board according to a second comparative example;
FIG. 9 is one example of graphs depicting crosstalk quantities between the respective differential signal vias with respect to the printed circuit board according to the embodiment;
FIG. 10 is one example of graphs depicting a comparison of the crosstalk quantity between when the GND via is provided and when not provided;
FIG. 11 is one example of graphs depicting the crosstalk quantities between the respective differential signal vias with respect to the printed circuit board according to the first comparative example;
FIG. 12 is one example of graphs depicting the crosstalk quantities between the respective differential signal vias with respect to the printed circuit board according to the second comparative example;
FIG. 13 is one example of graphs plotted when comparing the crosstalk quantities between the differential signal vias of the printed circuit boards;
FIG. 14 is one example of a diagram illustrating a configuration of a GND layer formed on the printed circuit board according to the embodiment;
FIG. 15 is one example of a configuration of the GND layer formed on the printed circuit board according to the first comparative example;
FIG. 16 is one example of a diagram that illustrates wiring patterns on respective wiring layers in the case of a 4-layer structure taken by the printed circuit board according to the embodiment; and
FIG. 17 is one example of wiring patterns on the respective wiring layers in the case of a 2-layer structure taken by the printed circuit board according to the embodiment.

### DESCRIPTION OF EMBODIMENTS

An embodiment will hereinafter be described. The embodiment demonstrated as below is a simple exemplification but does not limit the technical scope of the present application to the following mode.

### <Embodiment of Printed Circuit Board>

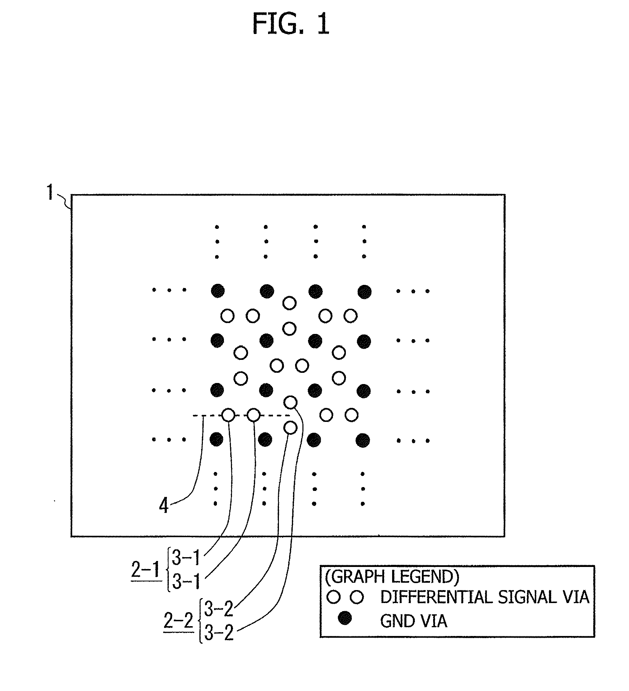

FIG. 1 is one example of a diagram illustrating a printed circuit board according to an embodiment. A printed circuit board 1 is a printed circuit board on which a plurality of wiring layers is stacked, and, as depicted in FIG. 1, a multiplicity of vias is disposed. The multiplicity of vias disposed on the printed circuit board 1 is classified into a differential signal via including a via-pair and a GND via disposed in the vicinity of each differential signal via. The printed circuit board 1 can be manufactured by stacking printed boards formed with wiring lines and thereafter providing the vias by forming through-holes across the respective layers throughout.

The differential signal vias establish connections between a plurality of wiring layers with the via-pairs. The respective differential signal vias are disposed so that the paired vias possessed by these vias are based on the following rule.

To be specific, the differential signal vias are disposed in such a manner that the paired-vias possessed by a specified differential signal via used for transmitting a differential signal different from a signal of another differential signal via adjacent thereto are aligned on a locus of a point that is distanced equally from the paired-vias possessed by another differential signal via. For example, as for a specified differential signal via 2-1, paired-vias 3-1, 3-1 possessed by this differential signal via 2-1 are aligned on a locus 4 of a point distanced equally from paired-vias 3-2, 3-2 possessed by another differential signal via 2-2 adjacent to the differential signal via 2-1 and used for transmitting the different signal different from the signal of the differential signal via 2-1. The locus 4 is coincident with a perpendicular bisector of a line segment that connects together the paired-vias 3-2, 3-2 possessed by the differential signal via 2-2.

The respective differential signal vias are disposed lengthwise and crosswise according to the rule described above, thus configuring a matrix. Namely, the respective differential signal vias arranged lengthwise and crosswise in arrays configuring the matrix, are disposed so that the paired-vias possessed by the vias are arranged on the loci of the points distanced equally from the respective paired-vias possessed by adjacent other differential signal vias, thus configuring the matrix.

The GND vias are disposed between the differential signal vias forming oblique arrays in the matrix configured by the differential signal vias. The GND vias are disposed for the purpose of reducing crosstalks between the differential signal vias forming the oblique arrays in the matrix configured by the differential signal vias.

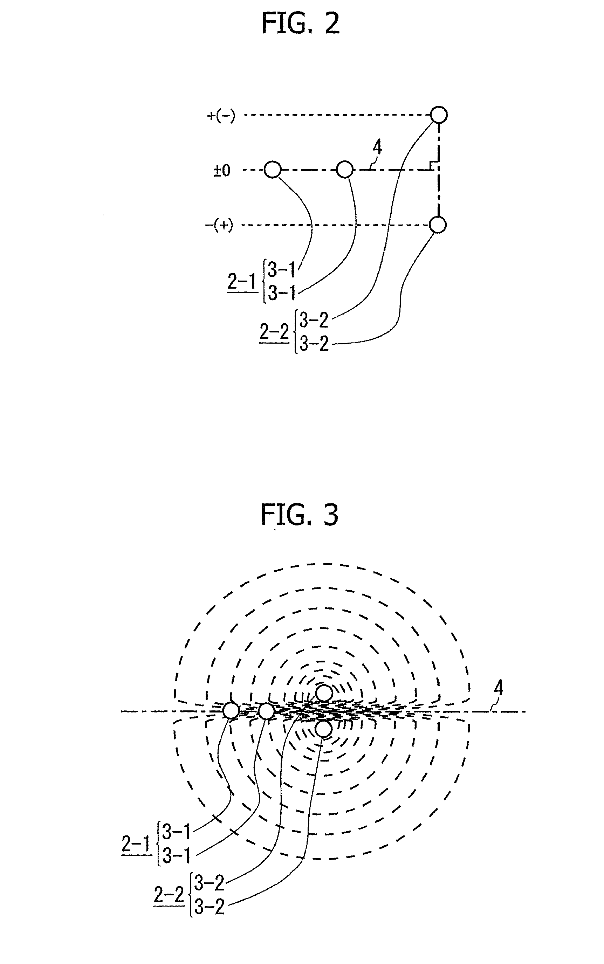

FIG. 2 is one example of a diagram simulating a positional relation between an electric field generated between the vias when the differential signals flow to the differential signal vias and the adj acent differential signal vias. Further, FIG. 3 is one example of a diagram simulating a magnetic field profile of a magnetic field generated when the differential signals flow to the differential signal vias. When the differential signals flow to the differential signal via 2-2, the electric field is generated due to an electric potential difference between the differential signals between the vias 3-2, 3-2 of the differential signal via 2-2. Further, when the differential signals flow to the differential signal via 2-2, the magnetic field is generated in the peripheries of the vias 3-2, 3-2 of the differential signal via 2-2. An intensity of the magnetic field gets stronger as an interval between magnetic field lines representing the magnetic field profile becomes narrower but weaker as the interval between the magnetic field lines becomes wider. For instance, the intensity of the magnetic field generated in the periphery of the differential signal via 2-2 gets, as illustrated in FIG. 3, stronger as it becomes closer to the differential signal via 2-2 but weaker as it is distanced farther from the differential signal via 2-2. Hence, the crosstalk coming from the differential signal via (e.g., the differential signal via 2-2) adjacent to the differential signal via 2-1 is dominant as a quantity of the crosstalk affecting the specified differential signal via 2-1, and it can be said that a degree of affecting the differential signal via positioned farther than the differential signal via 2-2 is small. Accordingly, it is effective to reduce the crosstalk of the adjacent differential signal via in order to effectivelyrestrain the crosstalk.

By the way, a differential signal method is a method of transmitting one signal by making use of an electric potential difference between the two signal lines, and hence, if noises are uniformly mixed in between the two signal lines, influence of the noises is cancelled. Herein, a capacitive crosstalk noise is caused by the electric field generated between the signal lines, however, in the case of the electric field generated between the two parallel signal lines for transmitting the differential signals, an electric potential level on a locus of a point distanced equally from these two signal lines is approximately equal to zero. Further, an inductive crosstalk noise is caused by a magnetic field generated in the periphery of the signal line, however, in the case of the magnetic field generated in the peripheries of the two parallel signal lines for transmitting the differential signals, an intensity of the magnetic field on the locus of the point distanced equally from the two signal lines is approximately equal. Such being the case, the printed circuit board 1 according to the embodiment relaxes the influence of the crosstalk nose from the adjacent differential signal via by disposing the vias so that the crosstalk noises having an equal quantity are mixed in the paired-vias possessed by the differential signal via.

Namely, the printed circuit board 1 according to the embodiment has a contrivance to relax the influence of the crosstalk noise by disposing the respective differential signal vias so that the paired-vias possessed by the specified differential signal via are arranged on the locus of the point distanced equally from the paired-vias possessed by another differential signal via adjacent to the specified differential signal via. For instance, as depicted in FIGS. 2 and 3, the paired-vias 3-1, 3-1 possessed by the specified differential signal via 2-1 are disposed so as to be arranged on the locus 4 of the point distanced equally from the paired-vias 3-2, 3-2 possessed by another differential signal via 2-2 adjacent to the specified differential signal via 2-1. Since the locus 4 of the point distanced equally from the paired-vias 3-2, 3-2 possessed by the differential signal via 2-2 is perpendicular to a direction of the electric field generated between the paired-vias 3-2, 3-2, the intensity of the electric field is fixed on the locus 4, and the magnetic fields generated in the peripheries of the vias 3-2, 3-2 are equilibrated with the result that the intensity of the magnetic field is also approximately fixed. Hence, the intensities of the capacitive crosstalk noise and the inductive crosstalk noise, which are mixed in between the paired-vias 3-1, 3-1 disposed on the locus 4, are the same in both of the vias 3-1, 3-1. Therefore, the paired-vias 3-1, 3-1 possessed by the differential signal via 2-1 are disposed on the locus 4, thereby substantially reducing the crosstalk noises.

Note that a focus is put on the two differential signal vias in FIGS. 2 and 3, however, the principle described above is a principle common to between the differential signal vias adjacent to each other on the arrays in the lengthwise direction and on the arrays in the crosswise direction of the matrix configured by the respective differential signal vias. The printed circuit board 1 is not, however, limited to the configuration that the entire differential signal vias are arrayed according to the rule described above. That is, the printed circuit board 1 maybe formed with the differential signal via possessed of the paired-vias not arranged on the locus of the point distanced equally from each of the paired-vias possessed by another differential signal via adjacent thereto.

A crosstalk reducing effect of the printed circuit board 1 according to the embodiment will hereinafter be verified. Two comparative examples will be given as below in order to verify the crosstalk reducing effect of the printed circuit board 1 according to the embodiment.

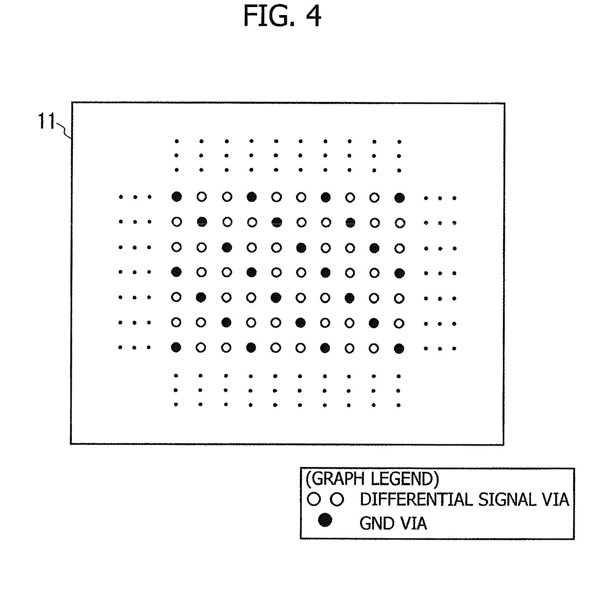

FIG. 4 is one example of a diagram illustrating aprinted circuit board according to a first comparative example. As depicted in FIG. 4, a multiplicity of vias is disposed on a printed circuit board 11. The multiplicity of vias disposed on the printed circuit board 11 is classified into the differential signal via including the via-pair and the GND via disposed in the vicinity of each differential signal via. The differential signal vias of the printed circuit board 11 according to the first comparative example are disposed so that the paired-vias possessed by the respective differential signal vias are arranged based on the following rule.

Namely, the respective differential signal vias formed in the printed circuit board 11 are disposed so that the paired-vias possessed by a specified differential signal via are arranged on an extension line of a line segment connecting together the paired-vias possessed by another differential signal via adjacent thereto. The GND via is disposed between the differential signal vias arranged on the extension line. Further, the GND vias are not disposed between the differential signal vias adjacent to each other in the oblique direction.

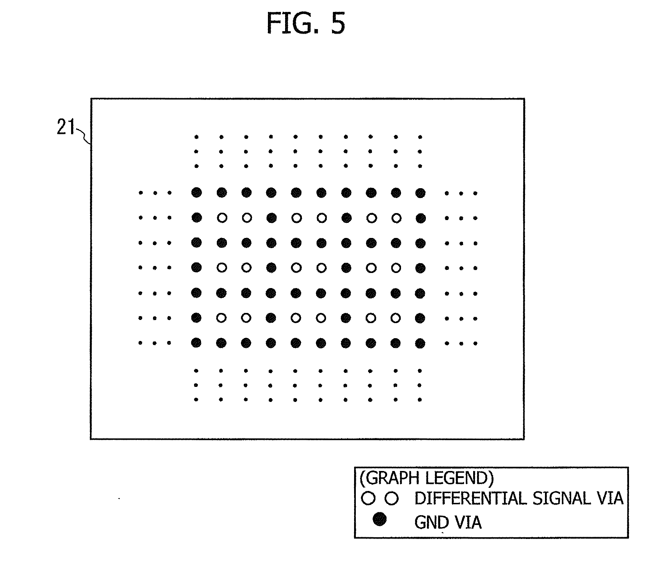

FIG. 5 is one example of a diagram illustrating a printed circuit board according to a second comparative example. As depicted in FIG. 5, a multiplicity of vias is disposed on the printed circuit board. The multiplicity of vias disposed on a printed circuit board 21 is classified into the differential signal via including the via-pair and the GND via disposed in the vicinity of each differential signal via. The differential signal vias of the printed circuit board 21 according to the second comparative example are disposed so that the paired-vias possessed by the respective differential signal vias are arranged based on the following rule.

Namely, the respective differential signal vias formed in the printed circuit board 21 are disposed so that the paired-vias possessed by a specified differential signal via are arranged on the extension line of the line segment connecting together the paired-vias possessed by another differential signal via adjacent thereto. The GND via is disposed between the differential signal vias arranged on the extension line. Moreover, the printed circuit board 21 according to the second comparative example is different from the printed circuit board 11 according to the first comparative example in terms of a point that the respective differential signal vias are completely surrounded by the GND vias.

Next, a quantity of the crosstalk of the differential signal via of each of the printed circuit boards 1, 11 and 21 will be calculated. In the calculation of the crosstalk quantity that is given as below, a pitch between the GND vias of the printed circuit board 1 according to the embodiment is set to 2 mm, and a pitch between the paired-vias possessed by each differential signal via is set to 1 mm. That is, a minimum pitch between the vias formed in the printed circuit board 1 of the embodiment is contrived not to be smaller than 1 mm. Further, in the printed circuit board 11 according to the first comparative example and the printed circuit board 21 according to the second comparative example, the pitch between the vias is set to 1 mm. Still further, an assumption is that consideration is taken not to cause the crosstalk between the wiring line connected to each differential signal via and the differential signal via. Moreover, the number of the wiring layers of each printed circuit board is "18", and the calculation is made in a way that establishes virtual ports at the wiring line, connected to the differential signal via, of the third layer counted from under and at the wiring line of the top layer. It is assumed that a line-width of the wiring line is set to 0.1 mm, and a wiring interval is set to 0.2 mm.

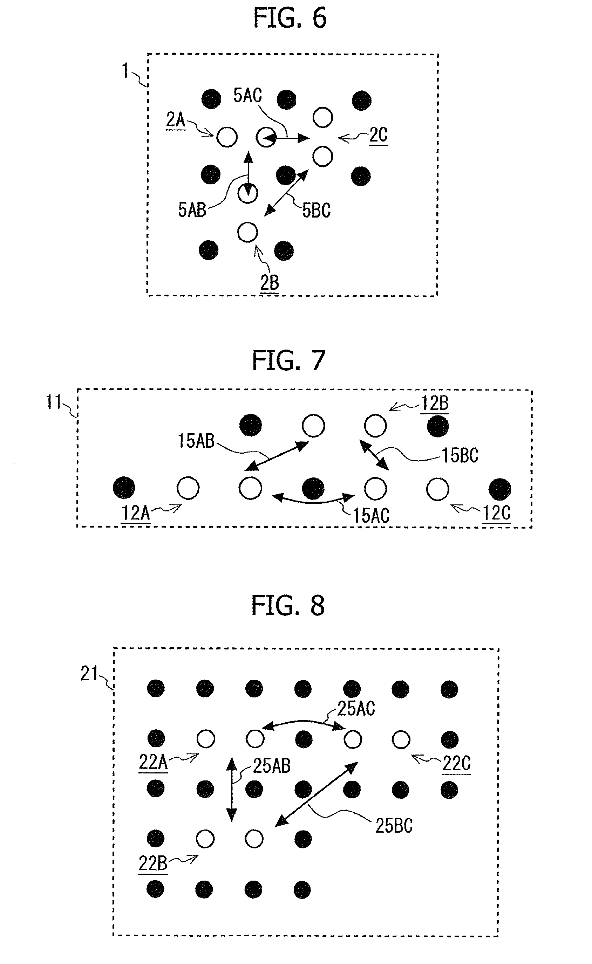

FIG. 6 is one example of a diagram illustrating the crosstalk set as a calculation target with respect to the printed circuit board 1 according to the embodiment. The calculation of the crosstalk in the printed circuit board 1 according to the embodiment involves limiting the adjacent differential signal vias set as the calculation targets to what is given as below because of there being a large calculation quantity when calculating the crosstalk quantities of the eight differential signal vias adjacent to the specified differential signal via, and setting a value given by quadrupling a calculation value thereof as the crosstalk quantity of the differential signal vias. To be specific, the calculation of the crosstalk quantities of the differential signal vias of the printed circuit board 1 according to the embodiment involves, in FIG. 6, using a crosstalk quantity 5AB between differential signal vias 2A, 2B having an up-and-down positional relation, a crosstalk quantity 5AC between differential signal vias 2A, 2C having a right-and-left positional relation and a crosstalk quantity 5BC between the differential signal vias 2B, 2C having an oblique positional relation, and adopting, as the crosstalk quantity of the specified differential signal via, a total value (the crosstalk is estimated from the eight peripheral portions) of values given by doubling the crosstalk quantity 5AB and the crosstalk quantity 5AC and quadrupling the crosstalk quantity 5BC.

FIG. 7 is one example of a diagram illustrating the crosstalk set as the calculation target with respect to the printed circuit board 11 according to the first comparative example. The calculation of the crosstalk quantities of the differential signal vias of the printed circuit board 11 according to the first comparative example involves, in FIG. 7, using a crosstalk quantity 15AB between differential signal vias 12A, 12B having a rightward-oblique positional relation, a crosstalk quantity 15BC between differential signal vias 12B, 12C having a leftward-oblique positional relation and a crosstalk quantity 15AC between the differential signal vias 12A, 12C having a right-and-left positional relation, and adopting a value given by doubling a total value thereof as the crosstalk quantity of the specified differential signal via.

FIG. 8 is one example of a diagram depicting the crosstalk set as the calculation target with respect to the printed circuit board 21 according to the second comparative example. The calculation of the crosstalk quantities of the differential signal vias of the printed circuit board 21 according to the second comparative example involves, in FIG. 8, using a crosstalk quantity 25AB between differential signal vias 22A, 22B having an up-and-down positional relation, a crosstalk quantity 25AC between differential signal vias 22A, 22C having a right-and-left positional relation and a crosstalk quantity 25BC between differential signal vias 22B, 22C having an oblique positional relation, and adopting, as the crosstalk quantity of the differential signal vias, a total value of values given by doubling the crosstalk quantity 25AB and the crosstalk quantity 25AC and quadrupling the crosstalk quantity 25BC.

Next, calculation results of calculating the crosstalk quantities between the respective differential signal vias of the printed circuit board 1 according to the embodiment by use of an analysis program, are given as follows.

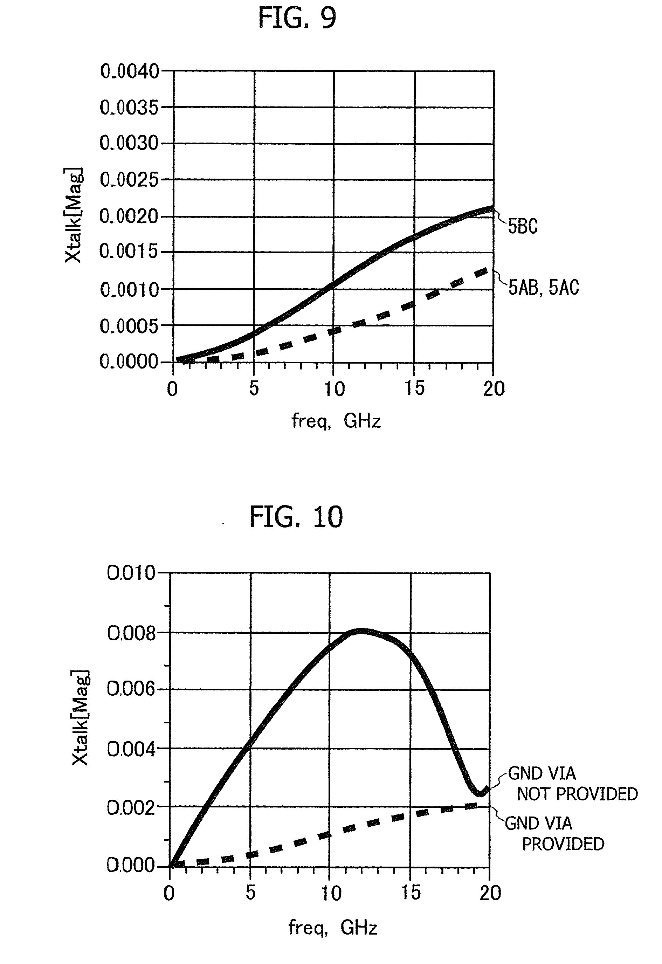

FIG. 9 is one example of graphs depicting the crosstalk quantities between the respective differential signal vias with respect to the printed circuit board 1 according to the embodiment. As apparent from the graph in FIG. 9, the crosstalk quantity 5AB has the same magnitude as that of the crosstalk quantity 5AC. Further, the magnitude of each of the crosstalk quantity 5AB and the crosstalk quantity 5AC is smaller than the magnitude of the crosstalk quantity 5BC. Hence, it is understood that an effect of reducing the crosstalk quantity owing to disposing the differential signal vias so that the respective paired-vias possessed by the specified differential signal via are arranged on the locus of the point distanced equally from the respective paired-vias possessed by another differential signal via adjacent to this specified differential signal via, is larger than a crosstalk quantity reducing effect owing to disposing the GND via between the differential signal vias.

Note that the crosstalk quantity 5BC in the case of omitting the GND vias from the printed circuit board 1 according to the embodiment is verified. FIG. 10 is one example of graphs depicting a comparison of the crosstalk quantity 5BC between when the GND via is provided and when not provided. In the case of omitting the GND via from the printed circuit board 1 according to the embodiment, as obvious from the graph in FIG. 10, the crosstalk quantity 5BC increases. Therefore, even when the differential signal vias are disposed so that the respective paired-vias possessed by the specified differential signal via are arranged on the locus of the point distanced equally from the paired-vias possessed by another differential signal via adjacent to this specified differential signal via, it is understood that the effectiveness is gained by disposing the GND via between the differential signal vias arranged in the oblique direction.

Next, calculation results of calculating the crosstalk quantities between the respective differential signal vias of the printed circuit board 11 according to the first comparative example by employing the analysis program, are given as below.

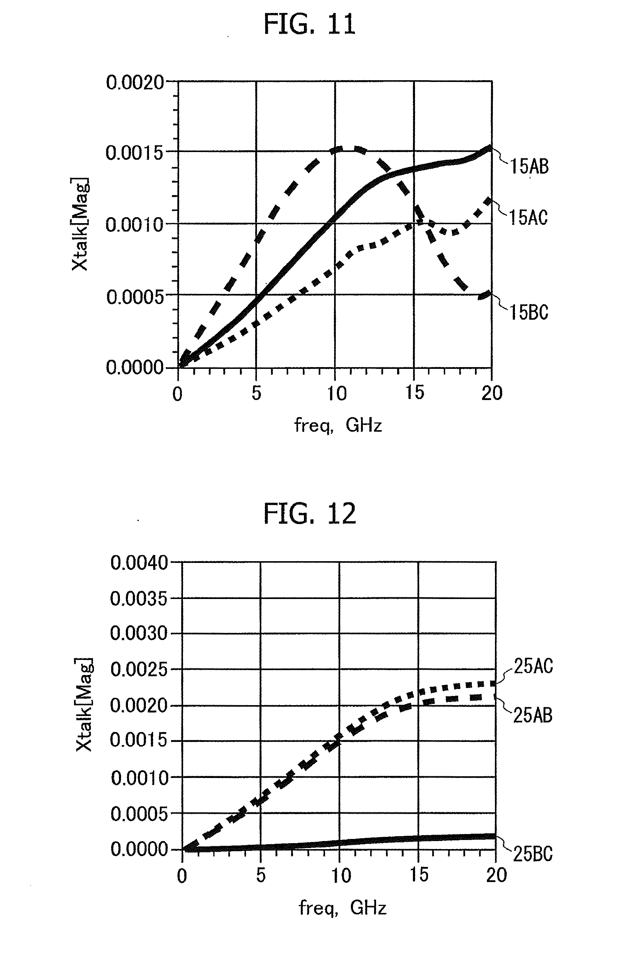

FIG. 11 is one example of graphs depicting the crosstalk quantities between the respective differential signal vias with respect to the printed circuit board 11 according to the first comparative example. As apparent from a comparison between the graph in FIG. 9 and the graph in FIG. 11, each crosstalk quantity of the printed circuit board 11 according to the first comparative example is, it is understood, larger than each crosstalk quantity of the printed circuit board 1 according to the embodiment on the whole.

Next, the calculation results of calculating the crosstalk quantities between the respective differential signal vias of the printed circuit board 21 according to the second comparative example by employing the analysis program, are given as below.

FIG. 12 is one example of graphs depicting the crosstalk quantities between the respective differential signal vias with respect to the printed circuit board 21 according to the second comparative example. As obvious from the graph in FIG. 12, a magnitude of a crosstalk quantity 25AB is approximately the same as that of the crosstalk quantity 25AC. Moreover, a magnitude of a crosstalk quantity 25BC is smaller than the magnitude of each of the crosstalk quantity 25AB and the crosstalk quantity 25AC.

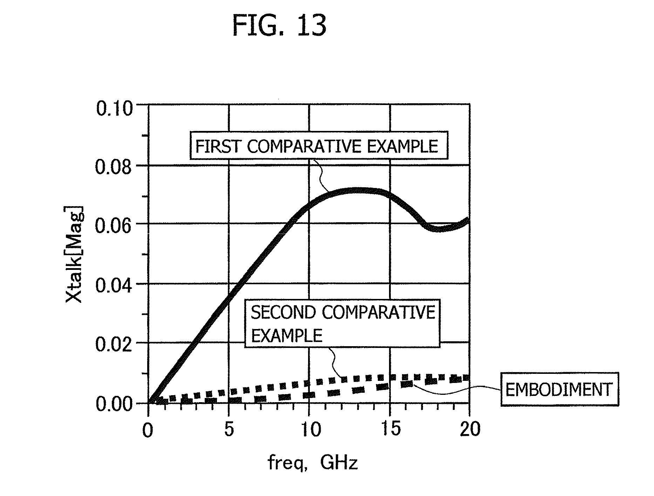

Subsequently, the calculation results of calculating the crosstalk quantities between the differential signal vias of the printed circuit boards 1, 11, 21 are given as below. FIG. 13 is one example of graphs plotted when comparing the crosstalk quantities between the differential signal vias of the printed circuit boards 1, 11, 21. In the graphs of FIG. 13, a line representing the "embodiment" indicates a total value of values given by doubling the crosstalk quantity 5AB and the crosstalk quantity 5AC and quadrupling the crosstalk quantity 5BC. Further, in the graphs of FIG. 13, a line representing the "first comparative example" indicates a doubled value of the total value of the crosstalk quantities 15AB, 15AC, 15BC. Further, in the graphs of FIG. 13 a line representing the "second comparative example" indicates the total value of the values given by doubling the crosstalk quantity 25AB and the crosstalk quantity 25AC and quadrupling the crosstalk quantity 25BC. As apparent from the graphs in FIG. 13, it is understood that the crosstalk quantities between the respective differential signal vias of the printed circuit board 1 according to the embodiment are smaller than the crosstalk quantities between the differential signal vias of each of the printed circuit board 11 according to the first comparative example and the printed circuit board 21 according to the second comparative example.

It is recognized that the printed circuit board 1 according to the embodiment is, as obvious from the graphs in FIG. 13, smaller than the first and second comparative examples in terms of the crosstalk quantity between the differential signal vias. Therefore, the embodiment enables the differential signal via count per unit area to be increased as compared with the second comparative example. Moreover, the embodiment enables the crosstalk noises mixed in the differential signals to be restrained as compared with the first and second comparative examples. Furthermore, the embodiment enables the via count of the GND vias, which is provided, to be decreased as compared with the second comparative example. In particular, the embodiment enables the crosstalk quantities to be well restrained simply by disposing the GND vias in the four positions peripheral to the differential signal via and is therefore, as apparent from the comparison with the second comparative example, capable of disposing the differential signal vias with a high density by reducing the GND vias to a great degree.

For example, the pitch between the GND vias of the printed circuit board 1 according to the embodiment is set to 2 mm, and the pitch between the paired-vias possessed by each differential signal via is set to 1 mm, in which case an exclusive area per differential signal via becomes 4 mm². By contrast, the pitch between the vias of the printed circuit board 21 according to the second comparative example is set to 1 mm, in which case the exclusive area per differential signal via becomes 6 mm². Namely, it is understood that the exclusive area per differential signal via can be reduced down to approximately two-thirds as compared with the printed circuit board 21 according to the second comparative example.

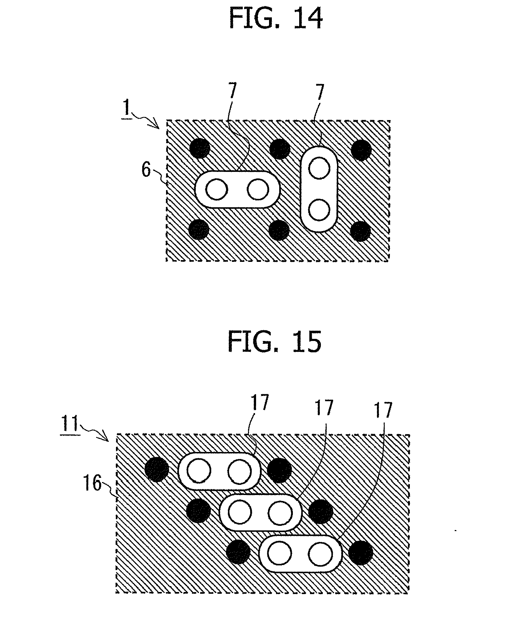

FIG. 14 is one example of a diagram illustrating a configuration of the GND layer formed on the printed circuit board 1 according to the embodiment. Further, FIG. 15 is one example of a configuration of the GND layer formed on the printed circuit board 11 according to the first comparative example. The GND layer is formed between the wiring layers on the printed circuit board for the purpose of reducing the crosstalk quantities between the respective wiring layers. In a GND layer 6 on the printed circuit board 1, a periphery of the differential signal via is cut out, thereby forming a clearance 7. In a GND layer 16 on the printed circuit board 11, similarly to the printed circuit board 1, a clearance 17 is provided in the periphery of the differential signal via. On the printed circuit board 1 according to the embodiment, however, each differential signal via is disposed so as to be arranged on the extension line of the line segment that connects the paired-vias possessed by another differential signal via adj acent thereto, and hence there is a wide interval between the differential signal vias. Hence, as obvious from a comparison between FIG. 14 and FIG. 15, the printed circuit board 1 according to the embodiment enables the clearance to be taken larger than on the printed circuit board 11 according to the first comparative example. Consequently, the printed circuit board 1 according to the embodiment has a larger degree of freedom in design than in the first and second comparative examples.

By the way, on the printed circuit board 1, the wiring lines (that are referred to as differential wiring lines as the case may be) on each wiring layer, which are connected to the respective differential signal vias, may also be formed in the following manner.

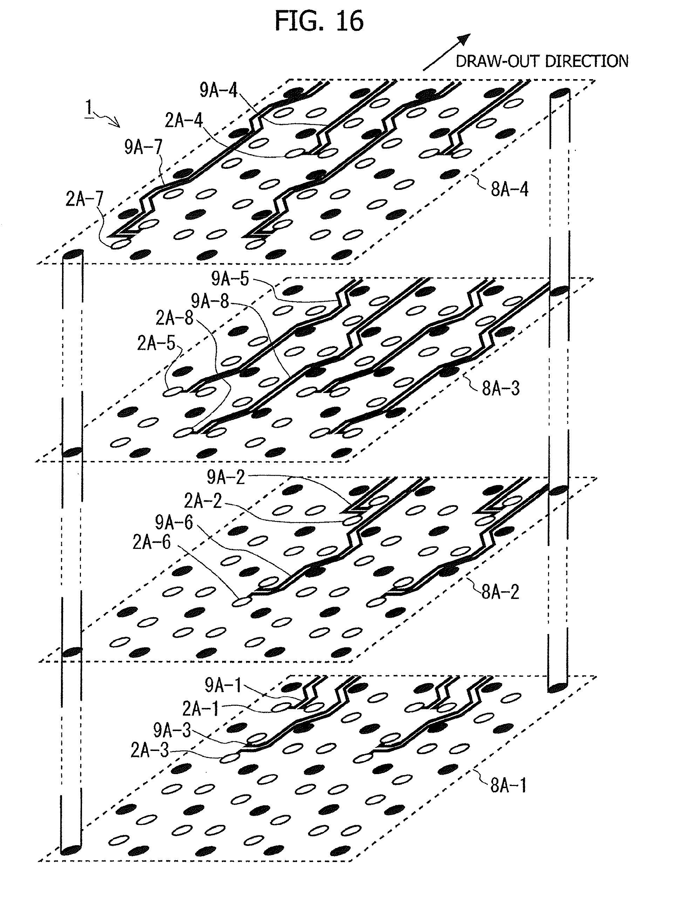

FIG. 16 is one example of a diagram that illustrates wiring patterns on the respective wiring layers in the case of a 4 - layer structure taken by the printed circuit board 1 according to the embodiment. FIG. 16 illustrates the differential signal vias and the GND vias, which are formed on each of wiring layers 8A-1 through 8A-4, separately between the layers, however, the respective vias are deemed to be formed in the way of penetrating the layers throughout. In the case of drawing out the wiring lines in the direction horizontal or vertical to the arrays of the matrix in which the differential signal vias are aligned, for instance, as illustrated in FIG. 16, the wiring lines can be arranged by use of the 4-layer wiring layers on the printed circuit board 1. In the example depicted in FIG. 16, four pairs of differential signal vias are disposed in the draw-out direction of the wiring lines. For example, a wiring line 9A-1 connected to the differential signal via 2A-1 existing at the first array counted from the side of the draw-out direction and a wiring line 9A-3 connected to the differential signal via 2A-3 existing at the second array counted from the side of the draw-out direction, are formed on the first wiring layer 8A-1 counted from under. Moreover, a wiring line 9A-2 connected to the differential signal via 2A-2 existing at the first array counted from the side of the draw-out direction and a wiring line 9A-6 connected to the differential signal via 2A-6 existing at the third array counted from the side of the draw-out direction, are formed on the second wiring layer 8A-2 counted from under. Still further, a wiring line 9A-5 connected to the differential signal via 2A-5 existing at the third array counted from the side of the draw-out direction and a wiring line 9A-8 connected to the differential signal via 2A-8 existing at the fourth array counted from the side of the draw-out direction, are formed on the third wiring layer 8A-3 counted from under. Yet further, a wiring line 9A-7 connected to the differential signal via 2A-7 existing at the fourth array counted from the side of the draw-out direction and a wiring line 9A-4 connected to the differential signal via 2A-4 existing at the second array counted from the side of the draw-out direction, are formed on the top wiring layer 8A-4. An assumption is that the GND vias are disposed at the pitch of 2 mm, the differential signal vias are disposed at the pitch of 1 mm, a wiring line width is 0.1 mm, and an interval between the wiring lines is 0.2 mm. Note that the differential signal vias and the wiring lines illustrated on the left side in FIG. 16 are described herein, however, the same description is applied to the differential signal vias and the wiring lines depicted on the right side. The wiring lines are formed repeatedly in the crosswise direction according to the condition described above in FIG. 16, thereby enabling the wiring lines to be formed without any interference with each other.

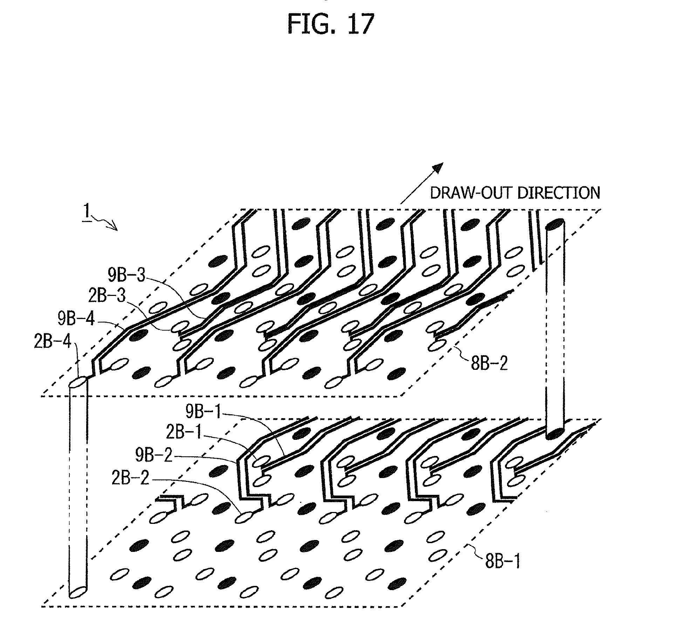

FIG. 17 is one example of wiring patterns on the respective wiring layers in the case of a 2-layer structure taken by the printed circuit board 1 according to the embodiment. FIG. 17 illustrates the differential signal vias and the GND vias, which are formed on each of wiring layers 8B-1 and 8B-2, separately between the layers, however, the respective vias are deemed to be formed in the way of penetrating the layers throughout. In the case of applying the 2-layer structure to the wiring lines connected to the differential signal vias, there is a possibility that the wiring lines interfere with each other, resulting in the increased crosstalk. For instance, in the case of configuring the printed circuit board 1 taking the 4-layer structure illustrated in FIG. 16 into the 2-layer structure as it is, the wiring lines are arranged in concentration in the deepest array where the differential signal vias 2A-1, 2A-2 are arranged, resulting in a narrowed interval between the wiring lines. This being case, if expanding the interval between the wiring lines, there is a possibility that an interval between the wiring line and the differential signal via gets narrowed, and the crosstalk quantity between the differential signal via and wiring line rises. Then, FIG. 17 presents one example of the wiring patterns capable of restraining the crosstalk quantities between the wiring lines and the crosstalk quantities between the wiring lines and the differential signal vias even when decreasing the number of the wiring layers.

On the printed circuit board 1 illustrated in FIG. 17, the draw-out direction of the wiring lines is inclined at 45 degrees to the arrays of the matrix where the differential signal vias are aligned. On the printed circuit board 1 illustrated in FIG. 17, similarly to the case in FIG. 16, it is assumed that the wiring line width is 0.1 mm, and the wiring line interval is 0.2 mm. The wiring lines connected to the respective differential signal vias are formed on the wiring layers taking the 2-layer structure according to a condition given below. For example, a wiring line 9B-1 connected to the differential signal via 2B-1 existing at the first array counted from the side of the draw-out direction and a wiring line 9B-2 connected to the differential signal via 2B-2 existing at the second array counted from the side of the draw-out direction, are formed on the wiring layer 8B-1 on the lower side. Further, a wiring line 9B-3 connected to the differential signal via 2B-3 existing at the third array counted from the side of the draw-out direction and a wiring line 9B-4 connected to the differential signal via 2B-4 existing at the fourth array counted from the side of the draw-out direction, are formed on the wiring layer 8B-2 on the upper side. The wiring lines are formed according to such a rule, whereby the wiring lines can be formed without any interference with the differential signal vias and the adj acent wiring lines. Moreover, if the respective wiring lines are formed inparallel with the direction inwhich the paired-vias possessed by the individual differential signal vias are arranged, the crosstalks exerted on the paired-vias of the differential signal vias from the wiring lines are approximately uniformed. Therefore, the wiring lines are, as illustrated in FIG. 17, formed in parallel with the direction in which the paired-vias possessed by the differential signal vias are arranged, thereby enabling the crosstalks between the differential signal vias and the wiring lines to be reduced.

Note that the draw-out direction of the wiring line is inclined at 45 degrees to the arrays of the matrix where the differential signal vias are aligned so as to enable the crosstalks to be effectively reduced on the printed circuit board 1 illustrated in FIG. 17 but is not limited to this angle as far as inclined. Namely, the angle in the draw-out direction of the wiring line to the arrays of the matrix can be properly varied within a range of 0 through 90 degrees.

Moreover, though being items common to the printed circuit board 1 depicted in FIGS. 16 and 17, the differential signal vias are provided as blind vias not formed over the whole wiring layers and as skip vias passing through a specified wiring layer, whereby the crosstalks between the differential signal vias and the wiring lines can be further reduced.

## Claims

1. A printed circuit board comprising:
a plurality of wiring layers; and
a plurality of differential signal vias to establish connections between the plurality of wiring layers through via pairs and to be disposed so that paired-vias possessed by a specified differential signal via for transmitting a differential signal different from a signal of another differential signal via adjacent thereto are arranged on a locus of a point distanced equally from each of the paired-vias possessed by another differential signal via.

2. The printed circuit board according to claim 1, wherein the locus is a perpendicular bisector of a line segment that connects together the paired-vias possessed by another differential signal via.

3. The printed circuit board according to claim 1 or 2, wherein the plurality of differential signal vias configures a matrix including arrays disposed lengthwise and crosswise, in which the specified differential signal via and another differential signal via are alternately arranged, and
the printed circuit board further comprises a GND via disposed between the differential signal vias configuring oblique arrays of the matrix.

4. The printed circuit board according to any one of claims 1 through 3, wherein the wiring layers are formed with wiring lines connected to the differential signal vias, and
the wiring lines are formed sideways of the specified differential signal via in a pattern parallel to a direction in which the paired-vias possessed by the specified differential signal via are arranged.

5. The printed circuit board according to any one of claims 1 through 4, wherein the wiring layers are formed with wiring lines connected to the differential signal vias in a predetermined direction from the differential signal vias, and
the plurality of differential signal vias is formed so that arrays of a matrix configured by disposing lengthwise and crosswise the arrays, in which the specified differential signal via and another differential signal via are alternately arranged, are oriented in a direction oblique to the predetermined direction.

6. A manufacturing method of a printed circuit board, the manufacturing method comprising:
forming, on a plurality of wiring layers, a plurality of differential signal vias to establish connections between the plurality of wiring layers through via pairs and to be disposed so that paired-vias possessed by a specified differential signal via for transmitting a differential signal different from a signal of another differential signal via adjacent thereto are arranged on a locus of a point distanced equally from each of the paired-vias possessed by another differential signal via.

7. The manufacturing method of the printed circuit board according to claim 6, wherein the locus is a perpendicular bisector of a line segment that connects together the paired-vias possessed by another differential signal via.

8. The manufacturing method of the printed circuit board according to claim 6 or 7, wherein the plurality of differential signal vias configures a matrix including arrays disposed lengthwise and crosswise, in which the specified differential signal via and another differential signal via are alternately arranged, and
the printed circuit board further comprises GND vias disposed between the differential signal vias configuring oblique arrays of the matrix.

9. The manufacturing method of the printed circuit board according to any one of claims 6 through 8, wherein the wiring layers are formed with wiring lines connected to the differential signal vias, and
the wiring lines are formed sideways of the specified differential signal via in a pattern parallel to a direction in which the paired-vias possessed by the specified differential signal via are arranged.

10. The manufacturing method of the printed circuit board according to any one of claims 6 through 9, wherein the wiring layers are formed with wiring lines connected to the differential signal vias in a predetermined direction from the differential signal vias, and
the plurality of differential signal vias is formed so that arrays of a matrix configured by disposing lengthwise and crosswise the arrays, in which the specified differential signal via and another differential signal via are alternately arranged, are oriented in a direction oblique to the predetermined direction.
